(19) Europäisches Patentamt
European Patent Office
Office européen des brevets

(11) EP 3 252 790 A1

(12) **EUROPEAN PATENT APPLICATION**
published in accordance with Art. 153(4) EPC

(43) Date of publication:
**06.12.2017 Bulletin 2017/49**

(21) Application number: **16743158.4**

(22) Date of filing: **18.01.2016**

(51) Int Cl.:
***H01G 9/20*** *(2006.01)*

(86) International application number:
**PCT/JP2016/051296**

(87) International publication number:
**WO 2016/121554 (04.08.2016 Gazette 2016/31)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **26.01.2015 JP 2015011904**

(71) Applicant: **Tanaka Kikinzoku Kogyo K.K.**
**Chiyoda-ku**
**Tokyo 100-6422 (JP)**

(72) Inventors:
- **INOUE, Kenichi**
  **Tsukuba-shi**
  **Ibaraki 300-4247 (JP)**
- **SATO, Hiroki**
  **Tsukuba-shi**
  **Ibaraki 300-4247 (JP)**

(74) Representative: **Weickmann & Weickmann PartmbB**
**Postfach 860 820**
**81635 München (DE)**

# (54) DYE-SENSITIZED SOLAR CELL AND METHOD FOR PRODUCING SAME

(57) The present invention relates to a dye-sensitized solar cell including an electrode having a substrate and at least one oxide layer formed on the substrate. Two or more dyes are carried on the oxide layer. Particularly, the oxide layer is toned by overlappingly carrying a dye for generating power which has a maximum light absorbable area in a wavelength region of 270 nm or more and less than 550 nm, and has a maximum molar absorption coefficient of 16000 or more and a dye for toning which has a maximum light absorbable area in a wavelength region of 550 nm or more and 800 nm or less. The L*a*b* color system of the oxide layer is that L* = 3 or more and 20 or less, a* = 0 or less, and b* = 0 or less. The present invention is a dye-sensitized solar cell which takes into consideration also design while exerting practical power generation efficiency.

Fig. 1

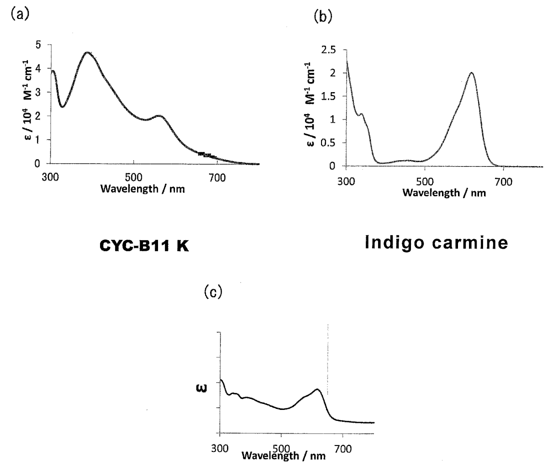


(a) CYC-B11 K

(b) Indigo carmine

(c) CYC-B11 + Indigo carmine

EP 3 252 790 A1

Printed by Jouve, 75001 PARIS (FR)

## Description

TECHNICAL FIELD

The present invention relates to a dye-sensitized solar cell. In particular, it relates to a dye-sensitized solar cell which takes into consideration a balance between property in design and power generation efficiency.

BACKGROUND ART

A dye-sensitized solar cell (hereinafter, referred to as DSC in some cases) is expected as a solar cell of the third generation since the dye-sensitized solar cell has both the high efficiency and the low production cost in comparison with a silicon solar cell (for example, single crystal silicon solar cell and multi-crystal silicon solar cell) which has already been put into practical use. The dye-sensitized solar cell is provided with an electrode which has a substrate, and an oxide layer formed on the substrate by printing, or the like.

Further, the property (power generation efficiency) of the dye-sensitized solar cell varies depending on nature of a dye to be carried, and in this connection various compounds are developed as such a dye. There are conventionally known, from the initial stage of the DSC development, an N3 dye and a similar compound Z907 dye. Furthermore, with respect to these dyes, there has been recently reported that a ruthenium complex, such as CYC-B1 or CYC-B11 which is a dye material having a high absorbance index (maximum molar absorption coefficient ε) and having a higher power generation ability in comparison with conventional products (PTL 1).

[Chemical formula 1]

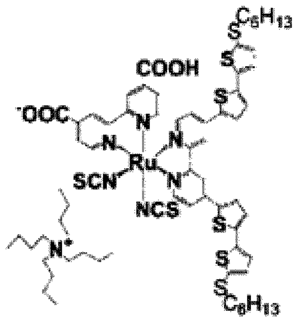

CYC-B11 Dye

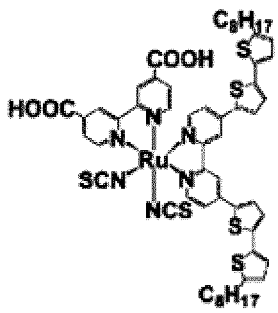

CYC-B1 Dye

On the other hand, there are used a layer where fine particles of an inorganic oxide, such as titanium oxide ($TiO_2$), zinc oxide (ZnO), vanadium oxide ($V_2O_5$), zirconium oxide ($ZrO_2$) or niobium oxide ($Nb_2O_5$) are layered. The oxide layer includes a main functional layer of the DSC which carries a dye and converts absorbed light to electron.

The dye-sensitized solar cell has many merits other than the power generation efficiency, and a specific feature among them is a high degree of freedom in shape. Namely, since a flexible plastic material in the form of film or sheet can be used as the substrate of DSC, the DSC can be freely settled not only on a roof but on a wall and the like. Further, using a transparent body as constituent materials of the substrate and the electrode makes it possible to see through the substrate and the electrode, and thus, the DSC can also be used on a window.

CITATION LIST

PATENT LITERATURE

PTL 1: Patent No. 5241546

SUMMARY OF INVENTION

TECHNICAL PROBLEM

Although the dye-sensitized solar cell is expected to provide advantages in design owing to its high degree of

freedom in shape, there is little prior case to utilize the property positively. The object of the present invention is to disclose the configuration of a dye-sensitized solar cell which takes into consideration also design while exerting practical power generation efficiency as a solar cell, and the method of manufacturing the same.

SOLUTION TO PROBLEM

The present inventors have focused on color of the dye-sensitized solar cell. The color is an important factor in design of product, and a colorful DSC is expected to be applied to various uses in building materials such as wall materials and window materials. Here, the color of the appearance of the DSC is influenced by the color of the dye material which is carried on the oxide layer. As a result of the intensive study, the present inventors have found a DSC which emits unprecedented color lights, and exhibits a sufficient power generation efficiency, and then have reached the present invention.

Namely, the present invention is a dye-sensitized solar cell, which includes an electrode having a substrate, and at least one oxide layer formed on the substrate; wherein two or more dyes are carried on the oxide layer, as the dye, at least one dye for generating power is carried which has a maximum light absorbable area in a wavelength region of 270 nm or more and less than 550 nm, and has a maximum molar absorption coefficient of 16000 or more, and an L*a*b* color system of the oxide layer is that L* = 3 or more and 20 or less, a* = 0 or less, and b* = 0 or less.

The present invention forms an oxide layer having particular colors by carrying a plurality of dyes while the specified dye is used as a main dye for generating power. Hereinafter, the present inventive dye-sensitized solar cell will be explained in detail. Note that, in the present invention, a molar absorption coefficient of each dye is a value measured by using DMF as a solvent.

The present inventive dye-sensitized solar cell is based on carrying a plurality of dyes on the oxide layer. Further, among the plurality of dyes, at least one dye which has a maximum light absorbable area in a wavelength region of 270 nm or more and less than 550 nm, and has a maximum molar absorption coefficient of 16000 or more is used as an essential dye for generating power. The reason why the dye having such particular light absorption characteristics is used is to ensure the necessary power generation efficiency as the DSC. Since, in the solar spectrum of visual ray area, an energy of the short wavelength area is high, it is preferable to use the dye having the maximum absorption area in this area as a dye for generating power. Further, by defining the maximum molar absorption coefficient to 16000 or more in this regard, it is possible to ensure the practically usable power generation efficiency. The maximum molar absorption coefficient is preferably 25000 or more, more preferably 30000 or more. Further, the maximum molar absorption coefficient is naturally preferable as high as possible, and the practical upper limit is set to be 500000 or less.

In addition, in the present inventive dye-sensitized solar cell, the L*a*b* color system of the oxide layer is that L* = 3 or more and 20 or less, a* = 0 or less, and b* = 0 or less. In the L*a*b* color system, L* shows brightness, a* and b* show chromaticity. The present oxide layer, through which a light source is seen, exhibits a color including blue or green color factor. According to the present inventors' knowledge, there has not been a DSC which provides blue or green color while having the practical properties. The present invention has the oxide layer where a new color is exhibited while the above dye for generating power is used and two or more dyes are carried overlappingly. With respect to the a* and b*, the present inventors expect a lower value of a* = -20, and b* = -20. Note that each value of the L*a*b* color system is a value of the surface of the oxide layer measured by using a colorimeter with a black background provided on a back side of the substrate.

Here, the principal of the toning by carrying a plurality of dyes will be explained in more detail. Color is classified to self-luminous color and object color, and the object color is classified to surface color and transparent color. The color in the present application means the surface color of the object of the DSC oxide layer. The surface color is a color which is emitted by reflecting light received from the light source on the object, and is characterized by the wavelength of the reflected light. On the other hand, the power generation reaction of the DSC is generated when the carried dye absorbs light of the particular wavelength area, and the light having the wavelength area which is not absorbed characterizes the color of dye as the reflected light.

Accordingly, in order to ensure the power generation efficiency of the DSC, it is preferable to absorb light having a wavelength area of high energy. From this point of view, in the present invention, there is employed the dye which has a maximum light absorbable area in a wavelength region of 270 nm or more but less than 550 nm, as the dye for generating power. Here, the light in the visual area of less than 550 nm corresponds to blue light or green light as a color. Accordingly, the dye for generating power is a dye which absorbs a blue light and a green light, and indicates a yellow light and a red light. Therefore, when the dye for generating power is carried solely, the obtained DSC indicates yellow or red, and there is a state where the colors of blue and green are disappeared. In the present invention, by combining a plurality of dyes, the blue light and the green light are exhibited.

The principal will be explained by referring to a specific example. Fig. 1(a) shows light absorption characteristics of CYC-B11 which is a dye applicable as the dye for generating power in the present invention. As shown in Fig. 1, CYC-B11 is a dye of red which has a maximum light absorbable area around 400 nm, and in this regard, a maximum value

of the molar absorption coefficient is 5 x $10^4$. On the other hand, Fig. 1(b) shows light absorption characteristics of indigo carmine (Blue No. 2) which is the other dye having light absorption characteristics completely different from CYC-B11. Indigo carmine is a dye having the maximum light absorbable area around 630 nm and is a blue dye. In the present invention, the dye for generating power such as CYC-B11 is carried on the oxide layer, and the other dye such as indigo carmine is carried concurrently as a dye for toning. In the light absorption characteristics of the whole dyes where the both dyes are overlappingly carried, as shown in Fig. 1(c), an absorption peak around 400 nm which appears in CYC-B11 will be disappeared. Therefore, the reflection of the light having a short wavelength area of around 400 nm appears, and the oxide layer will exhibit a color of blue or green.

As mentioned above, preferred specific means for toning in the present invention is to overlappingly carry the dye for toning in addition to the dye for generating power. Here, the dye for toning is a dye which has a maximum light absorbable area in a wavelength region of 550 nm or more and 800 nm or less. The reason is, when overlapping with the property of the dye for generating power, to inhibit light absorption in the short wavelength area.

The ability of power generation is not necessarily required to the dye for toning. The reason is that the dye for toning is used for adjusting the light absorption characteristics after carrying on the oxide layer, and the dye for generating power has a role of power generation. However, it is preferable that the dye for toning has an ability of power generation. If the dye for toning has the same ability of power generation as that of the dye for generating power, the total ability of the power generation of all the DSC will be high.

As mentioned above, the dye for toning is a dye which has a maximum light absorbable area in a wavelength region of 550 nm or more and 800 nm or less, and the light absorbability relates not only to the ability of power generation but also to the strength of the action of toning. The upper limit of the maximum molar absorption coefficient of the dye for toning is 500000 or less as same as the dye for generating power. However, the dye for toning is permissibly lower than the dye for generating power in terms of the light absorbability, the maximum molar absorption coefficient with 30000 or less, 25000 or less, further 16000 or less is usable. Even when the light absorbability of the dye for toning is low, the color adjustment of the oxide can be done by adjusting the carrying amount of the dye for toning, or carrying two or more kinds of the dye for toning. However, when the carrying amount of the dye for generating power is reduced due to the increase of the carrying amount of the dye for toning, the total power generation ability of the DSC becomes lowered. From this reason, it is preferable to use the dye for toning having the maximum molar absorption coefficient of 15000 or more.

The dye for generating power and the dye for toning may be carried one by one, respectively, and may be carried concurrently two or more, respectively. Here, with respect to the carrying amounts of the dye for generating power and the dye for toning, it is preferable that a ratio (M2/M1) of a carrying amount M2 (unit: number of moles) of the dye for toning to a carrying amount M1 (unit: number of moles) of the dye for generating power has the following Equation with respect to a ratio (ε2/ε1) of an average value ε2 of the maximum molar absorption coefficient in the maximum light absorbable area of the dye for toning to an average value ε1 of the maximum molar absorption coefficient in the maximum light absorbable area of the dye for generating power.

[Equation 1]

$$1.0 \leq (\varepsilon 2/\varepsilon 1) \times (M2/M1) \leq 30$$

When the (ε2/ε1) x (M2/M1) falls outside the above range, the color of the oxide layer becomes the other color system determined by the present application because of loss of toning, or a sufficient power generation efficiency cannot be obtained because reducing the light to be absorbed by the dye for generating power. More preferably, the (ε2/ε1) x (M2/M1) is 1 or more but 20 or less. Note that the average value (ε1, ε2) of the maximum molar absorption coefficient is a weight average calculated according to the carrying amount of each dye.

Further, specific examples of the usable dye for generating power include complex dyes having Ru as a center metal, such as Z907, Z907Na, CYC-B1, CYC-B3, CYC-B5, CYC-B6S, CYC-B7, CYC-B11, C106, C101, K-19, SK-1, and SK-2.

Moreover, specific examples of the dye for toning include D149, DN477, DN496, SQ-2, a zinc phthalocyanine complex, indigo carmine, and the like. As mentioned above, the dye for toning is not required to have the ability of power generation. Among the above specific examples, with respect to the zinc phthalocyanine and SQ-2, these dyes cannot be expected to have the power generation action substantially when iodide is used as an electrolyte. The present invention can exhibit a preferred power generation efficiency while these dyes are applied.

As explained above, the present inventive dye-sensitized solar cell is characterized by carrying additionally the dye for toning which is not targeted until now as the dyes to be carried on the oxide layer. The configuration other than this feature is basically the same as the configuration of the conventional DSC.

Glasses, organic plastics and the like may be used as the substrate. Examples of the organic plastics include

PET (polyethylene terephthalate), PEN (polyethylene naphthalate), PES (polyethylene sulfide), PO (polyolefin), or PI (polyimide). This is because that, in the DSC, since the substrate is a body for supporting the oxide layer and, also in many times, functions as a light receiving surface, the substrate preferably has a light transmittance. In addition, since the organic plastic is flexible, it is possible to produce a DSC having a flexible shape. A transparent electrode film, such as ITO or FTO, may be formed on the surface of the substrate made of such a material. Note that, a thickness of the transparent conductive film is 0.1 to 2.0 μm in many cases.

The oxide layer is composed of an oxide such as titanium oxide, zirconium oxide, vanadium oxide, manganese oxide, zinc oxide, niobium oxide, molybdenum oxide, indium oxide, tin oxide, tantalum oxide, or tungsten oxide. Particularly preferable is titanium oxide. As the above, the oxide layer may be formed by a multi-layered construction according to the desired function.

The oxide layer may be configured by a single layer or may be formed by a multi-layered construction. In recent DSC, the oxide layer may also be configured in a multi-layered construction according to the desired function. As an example of the oxide layer formed by a multi-layered construction, there is a configuration where a transparent layer which is a main functional layer of the DSC for carrying the dye and generating power is based, and laminating additional oxide layers for reflecting by light which cannot be caught by a transparent layer, a scattering layer and a reflecting layer which are reflected. Even when these oxide layers may be composed of the same material, the functions can be characterized by adjusting a particle size, a particle size distribution of the oxide particles. (One example is that the transparent layer is composed of an oxide having a particle size of 20 nm or less, and the scattering layer or the reflecting layer is composed of an oxide having a particle size of 100 nm or more.) The object to use the multi-layered construction of the oxide layers is to improve the power generation efficiency, but the oxide layer having such a multi-layered construction may be employed.

The thickness of the oxide layer is not particularly limited, but is preferably 0.5 μm or more but 30 μm or less. Such a layer of less than 0.5 μm will carry a too small amount of the dye, thereby loweing the power generation efficiency of the DSC. On the other hand, a layer of more than 30 μm will have difficulty in carrying the dye uniformly and sufficiently at the time when the dye is carried. The thickness of the oxide layer in this regard is a total thickness, and when configured by a plurality of layers, is sum of each layer.

Additives may be carried on the oxide layer in addition to the dye. As the additives, there is a co-adsorbent which is adsorbed to the oxide layer together with the dye and inhibits association of dye molecules. Examples of the co-adsorbent include organic materials, such as DINHOP (bis-(3,3-dimethyl-butyl)-phosphinic acid), CDCA (chenodeoxycholic acid), GBA (γ- guanidino butyric acid), and DPA (decyl phosphonic acid). However, the use of the co-adsorbent is not essential.

With respect to the configuration of the DSC, there are a counter electrode and an electrolyte which is immersed to the oxide layer, and the like, other than the above-described substrate, oxide layer and dyes, and these are the same as those of the conventional DSC.

Next, the present inventive manufacturing method of the dye-sensitized solar cell will be explained. The manufacturing steps of the DSC of the present invention are basically the same as the manufacturing method of the conventional DSC, and the main step is a step of bringing a dye solution into contact with the oxide layer formed on the substrate to carry the dye on the oxide layer.

As a method for forming the oxide layer on the substrate, there is a method of applying to the substrate a treating solution which is prepared by dispersing or dissolving the oxide powder (particles) in a proper solvent, and then drying and accumulating the oxide. After the drying, it is preferable to sinter at 400 to 600°C, and thereby a porous oxide layer having fine pores can be formed. When the oxide layer is configured in the multi-layered structure, the multi-layered structure can be obtained by repeating the application and sintering of the treating solution twice or more.

Then, the dye is carried by bringing the dye solution into contact with the oxide layer. The dye solution is prepared by dissolving the dye in a solvent. Here, in the present invention, at least one kind of both of the dye for generating power and the dye for toning are carried on the oxide layer. For carrying a plurality of dyes, it may be conducted by preparing a mixed dye solution containing both of the dye for generating power and the dye for toning, and then bringing the mixed dye solution into contact with the oxide layer. Alternatively, it may be conducted by preparing a dye solution of the dye for generating power and the dye solution of the dye for toning separately, and then bringing them into contact with the oxide layer in turn. Note that the mixed dye solution may be prepared by dissolving the dye for generating power and the dye for toning in one solvent, or by mixing dye solutions prepared separately.

Examples of the solvent of the dye solution include alcohol, such as t-butanol, DMF (N,N-dimethylformamide), GBL (γ-butyrolactone), DMSO (dimethylformamide), DMAc (N,N-dimethylacetoamide), DEF (N,N-diethylformamide), slufolane, N-methylpyrrolidone, dioxane, THF (tetrahydrofurane), dioxolane, dimethyl carbonate, and diethyl carbonate. A dye concentration of the dye solution is preferably adjusted within the range of 0.1 to 1% by mass. When carrying the additives, such as the co-adsorbent, on the oxide layer, the dye and the additives are preferably added to the solvent at the time of preparing the dye solution.

Specific examples for bringing the dye solution into contact with the oxide layer on the substrate include a

method of dipping the oxide layer into the dye solution together with the substrate (dipping), and a method of applying the dye solution to the oxide layer (coating). Examples of the coating include bar coating, blade coating, and screen printing, and any of them can be employed. Moreover, the adsorption step may be conducted at normal temperature and under atmospheric pressure, or may be conducted at a high temperature or under a reduced pressure. The adsorption step of the dye solution to the oxide layer may be conducted to the separated substrate batchwise, or may be conducted by Roll to Roll system by using a long substrate.

After the completion of the adsorption step of the dye solution, the obtained substrate may be subjected to proper washing and drying. After the step, according to the general manufacturing steps of DSC, the counter electrode is formed on the oxide layer, and then the electrolyte layer is formed between the counter electrode and the substrate.

## ADVANTAGEOUS EFFECTS OF INVENTION

As explained above, the present inventive dye-sensitized solar cell exhibits the unprecedented color while maintaining the practical usable power generation efficiency. The present inventive dye-sensitized solar cell has an excellent design, and is useful for various building materials, such as walls and windows, other than the roof materials.

## BRIEF DESCRIPTION OF DRAWINGS

Fig. 1 is an explanation view of light absorption properties of (a) CYC-B11, (b) Indigo carmine, (c) when both are overlappingly used, for explaining the mechanism of color tone adjustment of the present inventive DSC.

Fig. 2 is an explanation view of light absorption properties of the dyes (CYC-B11, DN477, DN-496, SQ-2) used in the first and second embodiment.

Fig. 3 is an explanation view of light absorption properties of the dyes (CYC-B11, zinc phthalocyanine tetracarboxylic acid) used in the present embodiment.

## DESCRIPTION OF EMBODIMENTS

Hereinafter, preferred embodiments of the present invention will be explained.

First Embodiment: In the present embodiment, with respect to the dyes to be carried on the oxide layer, a DSC was manufactured by using CYC-B11 as the dye for generating power. DSCs were manufactured by preparing three dyes of DN477, DN496, and SQ-2 as the dyes for toning, and carrying concurrently each dye together with CYC-B11. With respect to the light absorption characteristics of each dye used in the present embodiment, wavelength-absorption coefficient curves are shown in Fig. 2.

In the manufacturing of the DSC, firstly, an oxide layer was formed on a glass substrate (galas substrate with FTO film manufactured by AGC Fabritec Co., Ltd., size 15 mm x 25 mm x thickness 1.8 mm). The oxide layer was formed by applying a titanium oxide paste (Trade name: Ti-Nanoxide T/SP manufactured by Solaronix SA), sintering at 200°C x 15 min., and thereafter applying the same paste and sintering at 450°C x 30 min. The thickness of the titanium oxide layer was 5 μm.

Next, the substrate on which the oxide layer was formed was dipped into a dye solution to carry the dye. The dye solution was prepared by using 10 mL of DMSO as a solvent, and adding a plurality of dyes in a combined manner. In this regard, a concentration of CYC-B11 dye was 0.3 M, and based on this concentration, various solutions containing various carrying ratios were prepared. The dye was carried by dipping the substrate into the dye solution (temperature 25°C) for 60 min. In the present embodiment, the combinations of the carried dyes (for generating power and for toning) are as follows.

[Table 1]

| | Dye for generating power + Dye for toning | M2/M1 | ε2/ε1 | (ε2/ε1) x (M2/M1) |
|---|---|---|---|---|
| Example 1 | CYC-B11 + DN477 (1 : 1) | 1.0 | 2.0 | 2.0 |
| Example 2 | CYC-B11 : + DN496 | 1.0 | 1.0 | 1.0 |
| Example 3 | CYC-B11 + SQ-2 (1 : 1) | 1.0 | 6.4 | 6.4 |
| Example 4 | CYC-B11 + SQ-2 (1 : 2) | 2.0 | 6.4 | 12.8 |
| Example 5 | CYC-B11 + DN477 + SQ-2 (1 : 0.75 : 2) | 2.75 | 7.2 | 19.8 |

(continued)

| | Dye for generating power + Dye for toning | M2/M1 | ε2/ε1 | (ε2/ε1) x (M2/M1) |
|---|---|---|---|---|
| Example 6 | CYC-B11 + DN496 + SQ-2 (1 : 0.75 : 2) | 2.75 | 6.8 | 18.7 |
| Comparative example 1 | CYC-B11 (Dye for generating power) | - | - | - |
| Comparative example 2 | DN477 (Dye for toning) | - | - | - |
| Comparative example 3 | DN496 (Dye for toning) | - | - | |
| Comparative example 4 | SQ-2 (Dye for toning) | - | - | - |

After carrying the dye, the substrate was taken out from the solution. With respect to the oxide layer after carrying the dye, each value of L*a*b* color system was measured. The color evaluation was conducted by setting a background of a black plate (ZERO BOX (black background L* = 1 or less) manufactured by NIPPON DENSHOKU INDUSTRIES Co., LTD.), putting thereon the substrate so that the oxide layer was upper side. The reason why the black background was used was to avoid the bad influence of the light having passed through the substrate to the measurement. Then, the brightness (L*) and the chromaticity (a*, b*) of the oxide layer were measured by a colorimeter (SA4000 manufactured by NIPPON DENSHOKU INDUSTRIES Co., LTD.). With respect to the measuring conditions, as the lighting and receiving conditions, the measurement was conducted by receiving the reflected light in the manner of n-45° post-dispersive spectroscopy according to JIS Z9722. The light source to be used was a halogen lamp 12 V 50 W. Note that the color was observed visually, or with naked eyes at that time. In the observation with naked eyes, the registered color was a color which was passed through the substrate from the light source (fluorescent lamp of the measuring room).

After measuring the color, a DSC was manufactured by assembling the platinum plate as the counter electrode, and filling the space between the both electrodes with an electrolyte of an acetonitrile solution of iodine.

The solar cell properties of the thus obtained DSC were evaluated. The evaluation test was conducted by using a solar simulator (manufactured by YAMASHITA DENSO Co., Ltd.) and radiating a simulated solar light (100 $mW/cm^2$), and measuring a conversion efficiency (Eff (%)). The color of the oxide layer and the cell properties of each DSC are shown in Table 2.

[Table 2]

| | Dye | Color system | | | Visually observed | Eff (%) |
|---|---|---|---|---|---|---|
| | | L* | a* | b* | | |
| Example 1 | CYC-B11 + DN477 (1 : 1) | 3.28 | -0.16 | -1.20 | Purple | 5.72 |
| Example 2 | CYC-B11 + DN496 (1 : 1) | 3.78 | -0.30 | -0.60 | Purple | 5.48 |
| Example 3 | CYC-B11 + SQ-2 (1 : 1) | 3.84 | -1.26 | 0.00 | Green | 3.97 |
| Example 4 | CYC-B11: 2) SQ-2 | 4.20 | -1.31 | -0.25 | Green | 3.97 |
| Example 5 | CYC-B11 + DN477 + SQ-2 (1 : 0.75 : 2) | 3.56 | -0.75 | -1.08 | Blue | 3.84 |
| Example 6 | CYC-B11 + DN496 + SQ-2 (1 : 0.75 : 2) | 3.64 | -0.70 | -0.69 | Blue | 3.82 |
| Comparative example 1 | CYC-B11 (Dye for generating power) | 4.31 | 1.30 | 0.75 | Reddish brown | 6.15 |
| Comparative example 2 | DN477 (Dye for toning) | 3.09 | 1.07 | -4.62 | Purple | 3.24 |
| Comparative example 3 | DN496 (Dye for toning) | 3.53 | -0.38 | -2.32 | Purple | 4.87 |
| Comparative example 4 | SQ-2 (Dye for toning) | 8.40 | -4.69 | -11.35 | Light blue | 1.59 |

The results from the viewpoint of color show that the oxide layer of every Example was apparently changed in color visually, with reference to the color (reddish brown) of the dye for generating power. This change of color is strongly influenced from the dye for toning. This color change is more apparent from the viewpoint of evaluation of the L*a*b* color system. From the values of a*, b* of CYC-B11 of the dye for generating power, they show that the dye indicated red and yellow. In Examples 1 and 2, the dye which has a minus value of b*, i.e. does not exhibit yellow color, was carried overlappingly to CYC-B11, and as a result, the yellow color disappeared in these Examples. Further, in Examples 3 and 4, the dye which has a minus value of a*, i.e. is green color (does not exhibit red color) was carried overlappingly

to CYC-B11, and thus, the red color disappeared from the oxide layer.

Next, conversion efficiency (Eff) of the DSC of each Example will be examined. As the results of the comparison of Example 1 and Comparative Example 2, and the comparison of Example 2 and Comparative Example 3, the conversion efficiency of each Example is increased in comparison with Comparative Example of the DSC where only the dye for toning is carried. Although these Examples changed in color greatly in comparison with the DSC (Comparative Example 1) where only the dye for generating power (CYC-B11) is carried, there was little decrease in performance. Further, comparing Examples 3 and 4 with Comparative Example 4, although Comparative Example 1 where SQ-2 is carried solely is considerably low in efficiency, when the dye for generating power is overlappingly carried, the efficiency is increased remarkably. Note that, even when a plurality of dyes for toning are carried, the practical conversion efficiency can be exhibited similarly (Examples 5 and 6).

Second Embodiment: Here, DSC where the oxide layer had a thickness of 3 μm were manufactured, while the combination of the dye for generating power and the dye for toning was the same as in the First Embodiment. The thickness of the oxide layer was controlled by a coating amount of the paste (Examples 7 to 10, Examples 12 to 13). Further, in this embodiment, a sample where a ratio of SQ-2 of the dye for toning was largely lowered (CYC-B11 : SQ-2 = 1:0.25, M2/M1 = 0.25, (ε2/ε1) x (M2/M1) = 1.6) than that in Example 4 was also manufactured (Example 11). Then, the same evaluation as in the First Embodiment was conducted. The results are shown in Table 2.

[Table 3]

| | Dye | Color system | | | Visually observed | Eff (%) |
|---|---|---|---|---|---|---|
| | | L* | a* | b* | | |
| Example 7 | CYC-B11 + DN477 (1 : 1) | 3.70 | -0.39 | -0.98 | Purple | 4.68 |
| Example 8 | CYC-B11 + DN496 (1 : 1) | 4.09 | -0.73 | -0.88 | Purple | 4.71 |
| Example 9 | CYC-B11 + SQ-2 (1 : 1) | 4.02 | -0.99 | -0.14 | Green | 4.05 |
| Example 10 | CYC-B11 + SQ-2 (1 : 2) | 3.96 | -1.66 | -0.22 | Green | 4.47 |
| Example 11 | CYC-B11 + SQ-2 (1 : 0.25) | 4.92 | -0.65 | -0.14 | Green | 5.70 |
| Example 12 | CYC-B11 + DN477 + SQ-2 (1 : 0.75 : 2) | 3.50 | -0.85 | -1.14 | Blue | 4.11 |
| Example 13 | CYC-B11 + DN496 + SQ-2 (1 : 0.75 : 2) | 3.69 | -1.04 | -0.77 | Green | 3.99 |
| Comparative example 5 | CYC-B11 (Dye for generating power) | 4.41 | 0.55 | 0.39 | Reddish brown | 4.99 |
| Comparative example 6 | DN477 (Dye for toning) | 3.33 | 1.63 | -5.05 | Purple | 2.65 |
| Comparative example 7 | DN496 (Dye for toning) | 3.18 | -0.19 | -2.10 | Purple | 4.12 |
| Comparative example 8 | SQ-2 (Dye for toning) | 8.75 | -5.30 | -9.57 | Light blue | 1.51 |

Tendency of each Example is basically the same as that of the First Embodiment. In this embodiment, the thinned oxide layer carries less amount of dye, thereby resulting in lower conversion efficiency.

However, in the comparison of Examples 9 to 11 and Comparative Example 8 where SQ-2 was used, an interest result was found. Namely, considering the results of Examples 3 and 4 and Comparative Example 4 of the First Embodiment together, the conversion efficiencies of Examples 9 to 11 of this Embodiment having the thin oxide layer are high. In this point, from the results of Comparative Examples 4 and 8, SQ-2 has inherently a low conversion efficiency regardless of the thickness of the oxide layer. From the results of Examples 9 to 11, when SQ-2 is carried concurrently with the dye for generating power, there is a possibility that SQ-2 may exhibit a preferable conversion efficiency, in some cases, by regulating the thickness of the oxide layer. Particularly, in Example 11 where SQ-2 was added in a small amount, the conversion efficiency is higher than that of the case where CYC-B11 of the dye for generating power was used solely. Also the toning can be successfully achieved, which is interesting result.

Third Embodiment: In this Embodiment, DSC was manufactured by using CYC-B11 as the dye for generating power, and zinc phthalocyanine tetracarboxylic acid ($ZnPc(COOH)_4$) as the dye for toning. Further, with respect to the light absorption properties of zinc phthalocyanine tetracarboxylic acid, the wavelength-absorption coefficient curve is shown in Fig. 3.

The DSC was manufactured basically in the same manner as in the First and Second Embodiments, the titanium oxide paste was applied and sintered on the substrate to form the oxide layer, and then the substrate was dipped in the dye solution to carry the dyes. Here, the thickness of the titanium oxide was 5 μm .

The dye solution was prepared by adding CYC-B11 in a concentration of 75 μM, and zinc phthalocyanine

tetracarboxylic acid in a concentration of 300 μM in a 10 mL of DMSO as the solvent (ratio (M2/M1) of a carrying amount of the dye for toning to a carrying amount of the dye for generating power is 4/1). The substrate was dipped in the dye solution (temperature of 25 °C) for 10 minutes to carry the dyes. Then, after the color was measured in the same manner as in the First Embodiment, the DSC was manufactured.

[Table 4]

| | Dye | Color system | | | Visually observed | Eff (%) |
|---|---|---|---|---|---|---|
| | | L* | a* | b* | | |
| Example 14 | CYC-B11 + $ZnPc(COOH)_4$ | 5.72 | -1.56 | -0.66 | Green | 2.42 |
| Comparative example 9 | $ZnPc(COOH)_4$ | 44.06 | -8.23 | -7.21 | Green | 0.12 |

The zinc phthalocyanine tetracarboxylic acid used in this Embodiment is low in the power generation property in case that an iodine-based electrolyte is used, and is a dye which substantially does not generate power. This is also apparent from the results of Comparative Example 9. Also in case of using such a dye, when the dye for generating power is carried concurrently as shown in Example 13, 2% or more conversion efficiency can be obtained. Therefore, according to the present invention, it is also possible to use a dye which does not have the power generation ability as the dye for toning.

INDUSTRIAL APPLICABILITY

According to the present invention, a DSC which has an unprecedented color can be obtained. The DSC also exhibits practical power generation efficiency. The present inventive DSC can be applied to house materials, such as wall materials and window materials, and it is also possible to maximally have the specific merit of the DSC that can generate power while exhibiting functions and appearance required to the house materials.

## Claims

1. A dye-sensitized solar cell, comprising an electrode which has a substrate, and at least one oxide layer formed on the substrate; wherein

   two or more dyes are carried on the oxide layer,
   as the dye, at least one dye for generating power is carried which has a maximum light absorbable area in a wavelength region of 270 nm or more and less than 550 nm, and has a maximum molar absorption coefficient of 16000 or more, and
   an L*a*b* color system of the oxide layer is that L* = 3 or more and 20 or less, a* = 0 or less, and b* = 0 or less.

2. The dye-sensitized solar cell according to claim 1, wherein carried on the oxide layer is at least one dye for toning, which has a maximum light absorbable area in a wavelength region of 550 nm or more and 800 nm or less.

3. The dye-sensitized solar cell according to claim 2, wherein a ratio (M2/M1) of a carrying amount M2 of the dye for toning to a carrying amount M1 of the dye for generating power has a following relationship with respect to a ratio (ε2/ε1) of an average value ε2 of the maximum molar absorption coefficient in the maximum light absorbable area of the dye for toning to an average value ε1 of the maximum molar absorption coefficient in the maximum light absorbable area of the dye for generating power.

[Equation 1]

$$1.0 \leq (\varepsilon 2/\varepsilon 1) \times (M2/M1) \leq 30$$

4. The dye-sensitized solar cell according to any of claims 1 to 3, wherein the dye for generating power is at least one of Z907, Z907Na, CYC-B1, CYC-B3, CYC-B5, CYC-B6S, CYC-B7, CYC-B11, C106, C101, K-19, SK-1, and SK-2.

5. The dye-sensitized solar cell according to any of claims 2 to 4, wherein the dye for toning is at least one of D149,

DN477, DN496, SQ-2, a zinc phthalocyanine complex, and indigo carmine.

**6.** A manufacturing method of a dye-sensitized solar cell, the dye-sensitized solar cell being defined in any of claims 1 to 5, comprising a step of bringing a dye solution into contact with an oxide layer which is formed on a substrate to carry a dye on the oxide layer, wherein

the dye solution is a solution which contains two or more dyes, and
includes at least one dye, as the dye, for generating power which has a maximum light absorbable area in a wavelength region of 270 nm or more and less than 550 nm, and has a maximum molar absorption coefficient of 16000 or more.

Fig. 1

(a)

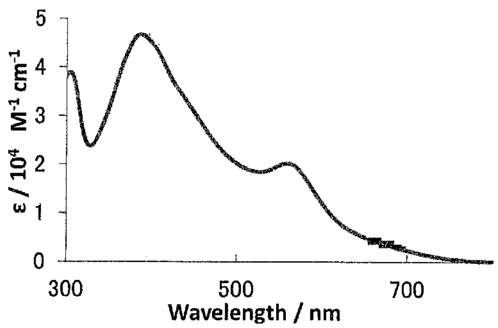


CYC-B11 K

(b)

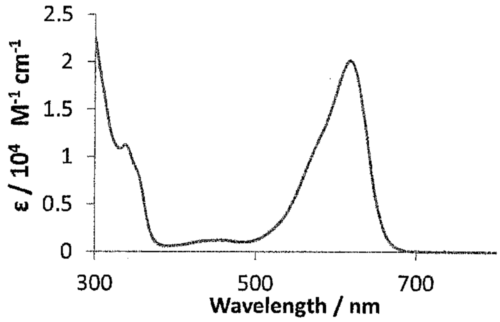


Indigo carmine

(c)

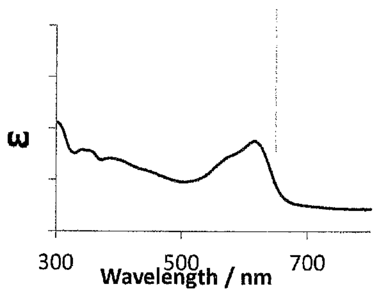


CYC-B11 + Indigo carmine

Fig. 2

Dye for generating power

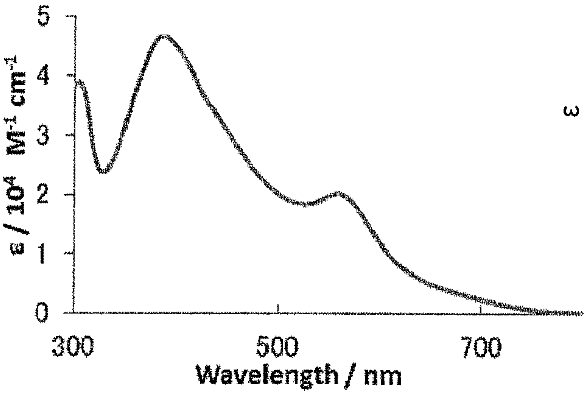


CYC-B11

Dye for toning

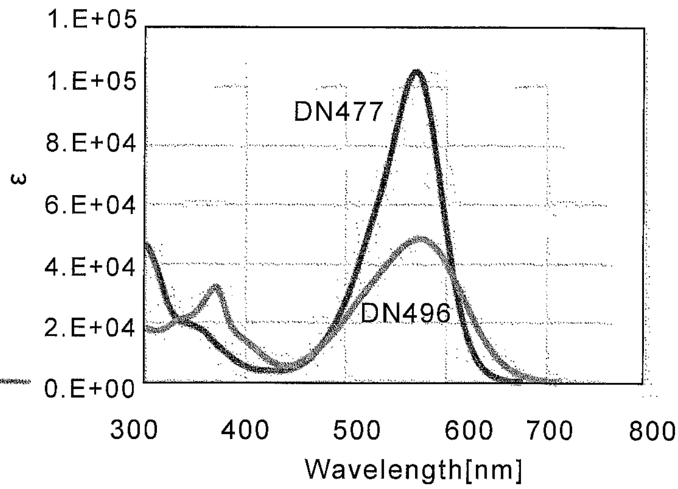


DN477 and DN496

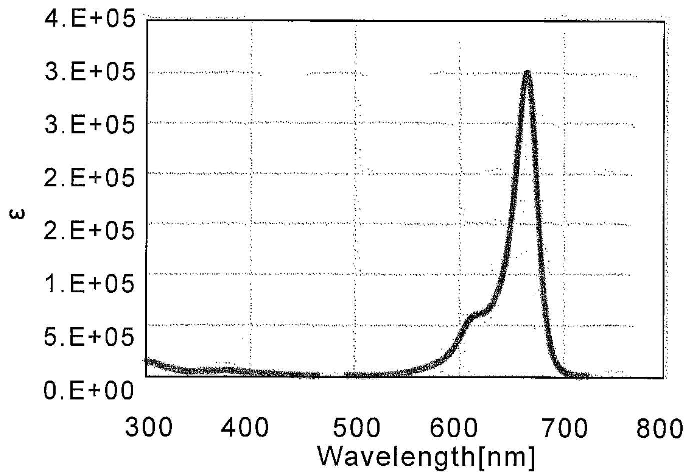


SQ-2

Fig. 3

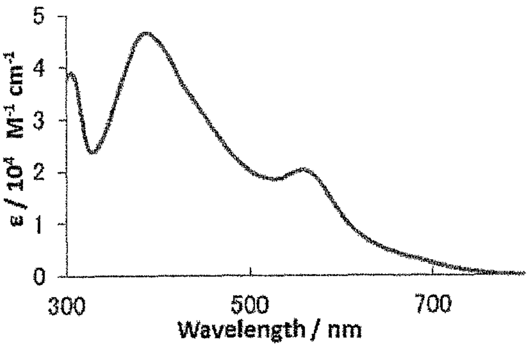


CYC-B11K

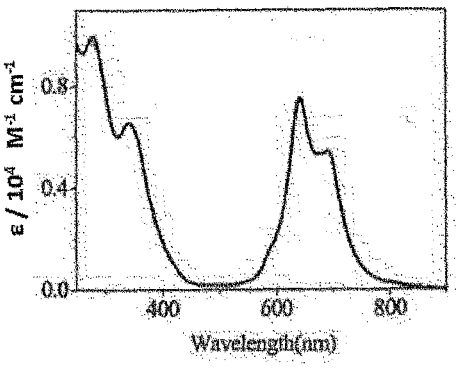


ZnPc(COOH)4

## INTERNATIONAL SEARCH REPORT

International application No.
PCT/JP2016/051296

A. CLASSIFICATION OF SUBJECT MATTER
*H01G9/20*(2006.01)i

According to International Patent Classification (IPC) or to both national classification and IPC

B. FIELDS SEARCHED

Minimum documentation searched (classification system followed by classification symbols)
H01G9/20, H01M14/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2008-84829 A (Sekisui Jushi Corp.), 10 April 2008 (10.04.2008), paragraph [0019] (Family: none) | 1-6 |
| Y | JP 2000-277786 A (Fuji Photo Film Co., Ltd.), 06 October 2000 (06.10.2000), paragraph [0041] (Family: none) | 1-6 |
| Y | JP 2009-215539 A (National Central University), 24 September 2009 (24.09.2009), claim 1; paragraphs [0093] to [0102] & US 2009/0209762 A1 claim 1; table 1; paragraphs [0089] to [0095] & TW 200936575 A & AU 2009200356 A & CN 101585972 A | 1-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 March 2016 (16.03.16) | 29 March 2016 (29.03.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/051296

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-268892 A (Fuji Photo Film Co., Ltd.), 29 September 2000 (29.09.2000), paragraph [0166] & EP 1020881 A2 paragraph [0122] | 6 |
| A | JP 2001-176565 A (Nokia Mobile Phones Ltd.), 29 June 2001 (29.06.2001), (Family: none) | 1 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 5241546 A